# EUROPEAN PATENT APPLICATION

(11) **EP 3 889 985 A1**
(43) Date of publication of application: **06.10.2021**
(21) Application number: 20167944.6
(22) Date of filing: 03.04.2020
(51) Int. Cl.: H01H 9/52, H01H 1/62, H02B 1/56

(54) **COOLING APPARATUS FOR A MEDIUM VOLTAGE OR HIGH VOLTAGE SWITCHGEAR**

(71) Applicant: ABB Schweiz AG, 5400 Baden (CH)
(72) Inventor: KEßLER, Michael, 42579 Heiligenhaus (DE); STADNICKI, Adrian, 40883 Ratingen (DE); SOLOGUBENKO, Oleksandr, 8906 Bonstetten (CH); FUßBAHN, Olaf, 40885 Ratingen (DE); CLAUS, Oliver, 40885 Ratingen (DE)
(74) Representative: Maiwald Patent- und Rechtsanwaltsgesellschaft mbH

(57) **Abstract**

The present invention relates to a cooling apparatus for a medium voltage switchgear, the cooling apparatus comprising:
- an evaporator section;
- a fluid conduit; and
- a condenser section.

The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to the fluid conduit. At least part of the evaporator section is electrically insulating. The at least part of the evaporator section that is electrically insulating is connected to the fluid conduit. The fluid conduit is fluidly connected to the condenser section. The cooling apparatus is configured such that in use a working fluid in the evaporator section is heated to a vapour state, and wherein the vapour is transferred by the fluid conduit to the condenser section, and wherein the vapour in the condenser section is condensed to the working fluid, and wherein the condensed working fluid is passively returned via the fluid conduit to the evaporator section.

## Description

### FIELD OF THE INVENTION

The present invention relates cooling apparatuses for a medium voltage or high voltage switchgear, medium voltage switchgear having such apparatuses, and methods of cooling at least one part of a medium voltage or high voltage switchgear with a cooling apparatus.

### BACKGROUND OF THE INVENTION

As compartments of gas insulated switchgears are fully sealed, heat dissipation due to losses is one of the major tasks of thermal management of the panel. For high current ratings in medium voltage switchgears passive cooling elements are used such as heat sinks or gas coolers. A more compact solution with very high efficiency consists of heat pipes. They are able to deduct heat from a dedicated hot spot to areas with lower temperature. Usually heat pipes consists of metallic tubes that provide an excellent tightness for fluids and gases and are also able to manage pressure increases in the tube during operation.

WO2013/139666A1 describes a cooling apparatus for a switchgear. The switchgear has one or more primary contacts constructed and arranged to connect to a terminal of a circuit breaker. The cooling apparatus includes an evaporator constructed and arranged to be associated with each primary contact. A condenser is located at a higher elevation than the evaporator. Fluid conduit structure fluidly connects the evaporator with the condenser. A portion of the fluid conduit structure defines a busbar tube electrically connected with an associated primary contact and defining a busbar of the switchgear. Working fluid is in the evaporator so as to be heated to a vapour state, with the fluid conduit structure being constructed and arranged to transfer the vapour to the condenser and to passively return condensed working fluid back to the evaporator for cooling the at least one primary contact and the associated busbar tube.

US6574094B1 describes a method for cooling bus bars in order to increase their current-carrying capacity while saving space and weight. The method comprises the steps of providing a housing having an interior wall; locating a distribution manifold within the housing, the distribution manifold comprising a hollow bus bar; communicating to the manifold a supply of an evaporative coolant; and delivering the coolant outwardly under pressure so that upon exiting the manifold, the coolant undergoes a phase change from the liquid to the vapor state. Heat is extracted from the manifold at least as quickly as heat is generated by the flow of current. The extraction of heat by the flow of coolant and evaporation maintains or lowers the temperature of the bus bar and enables a given size of bus bar to carry more current without a significant rise in temperature.

WO2013/139942A1 describes a cooling apparatus is for a switchgear having at least one primary contact to connect to a terminal of a circuit breaker, with a busbar joint connected to the primary contact. The cooling apparatus includes an evaporator associated with the primary contact. A condenser is located at a higher elevation than the evaporator. Heat pipe structure fluidly connects the evaporator with the condenser. Heat transfer structure is coupled with the busbar joint for removing heat from the busbar joint. Working fluid is in the evaporator so as to be heated to a vapor state, with the heat pipe structure transferring the vapor to the condenser and passively returning condensed working fluid back to the evaporator for cooling the at least one primary contact.

WO2012/161930A1 describes a cooling apparatus for cooling a switchgear. The switchgear has one or more primary contacts supported by a bushing and constructed and arranged to connect to a terminal of a circuit breaker. The cooling apparatus includes at least one evaporator associated with each primary contact, a condenser apparatus located at a higher elevation than the at least one evaporator, fluid conduit structure connecting the at least one evaporator with the condenser apparatus, and electrically insulating working fluid in at least one evaporator so as to be heated to a vapor state, with the fluid conduit structure being constructed and arranged to transfer the vapor to the condenser apparatus and to passively return condensed working fluid back to the at least one evaporator.

WO2015/018443A1 describes a cooling apparatus cooling for an electrical or electronic device, comprising an at least partially hollow body containing a refrigerant and having a plurality of electrically conductive sections Each electrically conductive section has a respective coupling portion suitable to be operatively associated with a corresponding electrically conductive part of the electrical or electronic device, wherein the at least partially hollow body further comprises one or more electrically insulating sections. Each electrically insulating section is positioned between and electrically insulates from each other two adjacent electrically conductive sections.

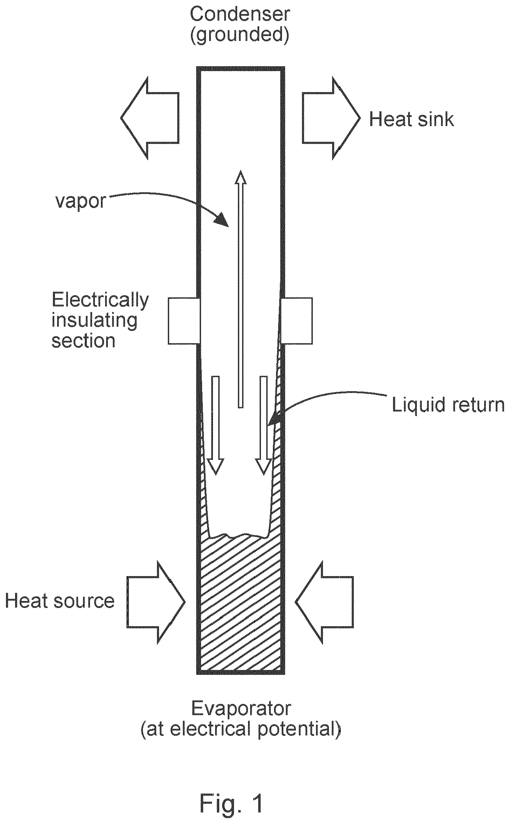

Usually metallic tubes of heat pipes cannot be connected directly to the hot spots on the current path due to dielectric reasons. Solutions that require that all parts stay inside the gas compartment usually cannot provide good cooling efficiency as the gas flow is limited inside a small, fully sealed compartment as is the case in medium voltage (MV) gas insulated switchgear (GIS). The highest efficiency can be obtained if there is a direct connection of the hot end of the heat pipe to the metallic part of the current leading path and the cold end of the heat pipes is placed outside the compartment. However, in this case an electrically insulating part must be integrated into the pipe. This then precludes using conventional heat pipes with capillary-driven liquid return, because the metallic wick has to be interrupted at the insulating part. Instead, gravity-driven heat pipes (normally called thermosyphons) have to be used, as schematically illustrated in Fig. 1. Thus, the heat pipe does not consists of one piece but of several parts, which must be gas tight connected. In addition a gas tight bushing through the sidewall of the switchgear is needed, leading to additional costs and assembling time.

There is a need to address these issues.

### SUMMARY OF THE INVENTION

Therefore, it would be advantageous to have an improved technique to cool internal parts of a medium voltage or high voltage switchgear that become hot due to current flow. Such a part is for example a part of a circuit breaker.

The object of the present invention is solved with the subject matter of the independent claims, wherein further embodiments are incorporated in the dependent claims.

In a first aspect, there is provided a cooling apparatus for a medium voltage switchgear, the cooling apparatus comprising:
- an evaporator section;
- a fluid conduit; and
- a condenser section.
The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to the fluid conduit. At least part of the evaporator section is electrically insulating. The at least part of the evaporator section that is electrically insulating is connected to the fluid conduit. The fluid conduit is fluidly connected to the condenser section. The cooling apparatus is configured such that in use a working fluid in the evaporator section is heated to a vapour state, and the vapour is transferred by the fluid conduit to the condenser section, and the vapour in the condenser section is condensed to the working fluid, and the condensed working fluid is passively returned via the fluid conduit to the evaporator section.

In this way, the cooling apparatus can cool the current carrying contact of a medium voltage or high voltage switchgear.

Thus, a heat pipe or thermosyphon is provided where the condensing section can be outside the switchgear enclosure or have a part outside the enclosure or be part of the other surface of the enclosure and no specific extra insulating part needs to be integrated into the fluid conduit. This is because although the current carrying part is at high voltage, because the evaporation section wherein it connects to the fluid conduit is inherently electrically insulating at the evaporator section of the cooling apparatus, the fluid conduit is not raised to high potential and the condenser section can be maintained at the potential of the enclosure of the switchgear, for example ground potential.

In an example, a part of the fluid conduit that is connected to the evaporator section is electrically insulating.

Thus, electrical insulation is improved because not only is the part of the cooling apparatus that contacts a high voltage part electrically insulating, but the first part of a fluid conduit that connects to that electrically insulating part is electrically insulating as well.

In an example, the evaporator section is configured to be affixed to a fixed contact or a movable contact of a circuit breaker of the medium voltage switchgear.

In this way, an efficient means is provided to cool a key component in a medium voltage switchgear that otherwise could become too hot.

In an example, the evaporator section is configured to slide over an end of the fixed contact or slide over an end of the movable contact.

In this manner, the cooling apparatus can be retrofitted to existing circuit breakers, where after positioning of the evaporator section it can be fixed in place for example with epoxy resin.

In an example, a part of the fluid conduit comprises a metallic bellows, such that the part of the fluid conduit comprising the metallic bellows can bend and/or extend longitudinally.

In this way, the cooling apparatus can deal with vibrations and/or be fitted to moving parts such as a movable contact of a circuit breaker. Thus, a condenser section of the cooling apparatus can be mounted externally to a compartment of a medium voltage switchgear, with the evaporator section mounted to fixed to a current carry part. The fluid conduit then passes through a wall of the compartment and can be mounted to the wall. However, positioned inboard of the wall, a bellows section of the fluid conduit provides for vibration isolation such that vibrations are prevented from passing from parts of the cooling apparatus inside the compartment to the condenser section outside.

In an example, at least part of the fluid conduit comprises a metallic tube.

In this manner, robustness of the apparatus is provided.

In an example, a metallic wick is comprised within the fluid conduit.

Thus, because the fluid conduit is not raised to high potential, a wick can be placed in the fluid conduit, and the passive return of the condensed working fluid from the condenser section to the evaporator section can make use of capillary action. Thus, not only is the efficiency of passive return of fluid increased, the condenser section need not be placed above the evaporator section.

In a second aspect, there is provided a medium voltage switchgear, comprising:
- a circuit breaker; and
- a cooling apparatus according to the first aspect.
The cooling apparatus is affixed to a contact of the circuit breaker. The contact of the circuit breaker is a fixed contact of the circuit breaker or is a movable contact of the circuit breaker.

In an example, the evaporator section of the cooling apparatus surrounds at least part of the contact of the circuit breaker such that fluid within the evaporator section can contact an outer surface of the contact of the circuit breaker that extends over the at least part of the contact. An epoxy resin extends over at least a part of the evaporator section and onto an outer surface of the contact on a first side of the evaporator section and/or onto an outer surface of the contact on a second side of the evaporator section.

In an example, the evaporator section is mounted on a raised section of the contact of the circuit breaker. A step joins the raised section to a lower section of the contact on a first side of the raised section and/or a step joins the raised section to a lower section of the contact on a second side of the raised section. The epoxy resin extends over the step on the first side and/or extends over the step on the second side.

Thus, the steps act as a key for the expoxy resin, providing for a very secure mounting of the evaporator section to the contact of the circuit breaker.

In a third aspect, there is provided a cooling apparatus for a medium voltage switchgear, the cooling apparatus comprising:
- an evaporator section;
- two fluid conduits; and
- a condenser section.
The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to each of the two fluid conduits. At least part of the evaporator section is electrically insulating. The at least part of the evaporator section that is electrically insulating is connected to each of the two fluid conduits. Each of the two fluid conduits fluidly is fluidly connected to the condenser section. The cooling apparatus is configured such that in use a working fluid in the evaporator section is heated to a vapour state, and the vapour is transferred by a first fluid conduit of the two fluid conduits to the condenser section, and the vapour in the condenser section is condensed to the working fluid, and the condensed working fluid is passively returned via a second fluid conduit of the two fluid conduits to the evaporator section.

In this way, the cooling apparatus can cool the current carrying contact of a medium voltage or high voltage switchgear, and efficiency of cooling is improved because by having two fluid conduits a circulation of the liquid and gaseous phase of the working fluid is enabled.

In a fourth aspect, there is provided a medium voltage switchgear, comprising:
- a circuit breaker; and
- a cooling apparatus according to the third aspect.
The cooling apparatus is affixed to a contact of the circuit breaker. The contact of the circuit breaker is a fixed contact of the circuit breaker or is a movable contact of the circuit breaker.

In an example, the evaporator section of the cooling apparatus surrounds at least part of the contact of the circuit breaker such that fluid within the evaporator section can contact an outer surface of the contact of the circuit breaker that extends over the at least part of the contact. An epoxy resin extends over at least a part of the evaporator section and onto an outer surface of the contact on a first side of the evaporator section and/or onto an outer surface of the contact on a second side of the evaporator section.

In a fifth aspect, there is provided a method of cooling at least one part of a medium voltage or high voltage switchgear with a cooling apparatus, the cooling apparatus comprising:
- an evaporator section;
- a fluid conduit; and
- a condenser section.
The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to the fluid conduit. At least part of the evaporator section is electrically insulating and wherein that at least part of the evaporator section that is electrically insulating is connected to the fluid conduit. The fluid conduit is fluidly connected to the condenser section. In this aspect, the method comprises:
heating a working fluid in the evaporator section to a vapour state;
transferring the vapour by the fluid conduit to the condenser section;
condensing the vapour in the condenser section to the working fluid; and
passively returning the condensed working fluid via the fluid conduit to the evaporator section.

In a sixth aspect, there is provided a method of cooling at least one part of a medium voltage or high voltage switchgear with a cooling apparatus, the cooling apparatus comprising:
- an evaporator section;
- two fluid conduits; and
- a condenser section.

The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to each of the two fluid conduits. At least part of the evaporator section is electrically insulating. the at least part of the evaporator section that is electrically insulating is connected to each of the two fluid conduits. Each of the two fluid conduits fluidly is fluidly connected to the condenser section. In this aspect, the method comprises:
heating a working fluid in the evaporator section to a vapour state;
transferring the vapour by a first fluid conduit of the two fluid conduits to the condenser section;
condensing the vapour in the condenser section to the working fluid; and
passively returning the condensed working fluid via a second fluid conduit of the two fluid conduits to the evaporator section.

In an example, a part of each of the two fluid conduits that is connected to the evaporator section is electrically insulating.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic illustration of a thermosyphon for cooling of heat sources at an electrical potential;
Fig. 2 shows an example of an evaporation section surrounding a current carrying contact - in this example a contact of a circuit breaker;
Fig. 3 shows an example of an evaporation section surrounding a current carrying contact - in this example a fixed contact of a circuit breaker; and
Fig. 4 shows an example of an evaporation section surrounding a current carrying contact, where the evaporator section has been clipped onto a fixed contact of a circuit breaker;
Fig. 5 shows an example of an evaporation section surrounding a current carrying contact - in this example a contact of a circuit breaker, where the contact of the circuit breaker has a step and where epoxy resin that fixes the evaporation section to the contact extend up to and keys into the step on either side;
Fig. 6 shows a cross-sectional view of the parts of the cooling apapratus together with connection components to outside of a gas tank of a medium voltage switchgear; and
Fig. 7 shows a cross-sectional view of connection components of the fluid conducit (heat-pipe) to outside of the gas tank with a compensation component also shown in the form of a bellows.

### DETAILED DESCRIPTION OF EMBODIMENTS

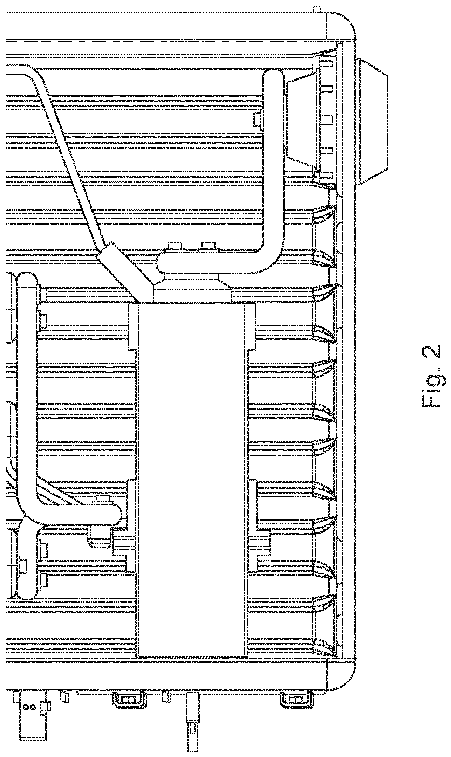

Figs. 2-7 relate to cooling apparatuses for a medium voltage switchgear, methods of cooling at least one part of a medium voltage voltage switchgear with a cooling apparatus. The cooling apparatus is described with respect to the cooling of a current carrying contact of a switchgear, and in particular that for a contact of a circuit breaker, but can be used to cool all manner of parts that form "hot spots" in such electrical equipment.

In an example of the cooling apparatus for a medium voltage switchgear the cooling apparatus comprises an evaporator section, a fluid conduit, and a condenser section. The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to the fluid conduit. At least part of the evaporator section is electrically insulating. The at least part of the evaporator section that is electrically insulating is connected to the fluid conduit. The fluid conduit is fluidly connected to the condenser section. The cooling apparatus is configured such that in use a working fluid in the evaporator section is heated to a vapour state, and the vapour is transferred by the fluid conduit to the condenser section, and the vapour in the condenser section is condensed to the working fluid, and the condensed working fluid is passively returned via the fluid conduit to the evaporator section.

In an example, the evaporator section is configured to completely surround the current carrying contact of a medium voltage switchgear. Thus, the evaporator section encircles the currying carrying contact.

In an example, the current carrying contact is configured to connect to a primary contact, that for example is configured to connect to a terminal of a circuit breaker of the switchgear.

In an example, the evaporator section is ring shaped.

In an example, the evaporator section comprises an insulating material such as thermoplastic.

In an example, the evaporator section comprises plastic and/or rubber materials.

In an example, the working fluid is electrically insulating.

In an example, the working fluid can be a refrigerant such as hydrofluorocarbons (e.g. R134a, R245fa), fluorketones (e.g., NOVEC-649™, commercially available from 3M).

According to an example, a part of the fluid conduit that is connected to the evaporator section is electrically insulating.

In an example, the part of the fluid conduit connected to the evaporator section comprises an insulating material such as thermoplastic.

In an example, the part of the fluid conduit connected to the evaporator section comprises an electrically insulating tube.

According to an example, the evaporator section is configured to be affixed to a fixed contact or a movable contact of a circuit breaker of the medium voltage switchgear. According to an example, the evaporator section is configured to slide over an end of the fixed contact or slide over an end of the movable contact.

According to an example, a part of the fluid conduit comprises a metallic bellows, such that the part of the fluid conduit comprising the metallic bellows can bend and/or extend longitudinally.

In an example, a first part of the fluid conduit on the condenser section side of the part that comprises a metallic bellows is metal and a second part of the fluid conduit on the evaporator section side of the part that comprises a metallic bellows is metal, and the first part is configured to be fixed to a wall of a compartment of the medium voltage switchgear.

According to an example, at least part of the fluid conduit comprises a metallic tube.

According to an example, a metallic wick is comprised within the fluid conduit.

Figures 2-7 also relate to a medium voltage switchgear thatcomprises a circuit breaker, and a cooling apparatus as described above. The cooling apparatus is affixed to a contact of the circuit breaker, where the contact is a fixed contact of the circuit breaker or the contact is a movable contact of the circuit breaker. Indeed, a first cooling can be attached to the fixed contact and a second cooling apparatus can be attached to a movable contact of the circuit breaker.

According to an example, the evaporator section of the cooling apparatus surrounds at least part of the contact of the circuit breaker such that fluid within the evaporator section can contact an outer surface of the contact of the circuit breaker that extends over the at least part of the contact. An epoxy resin extends over at least a part of the evaporator section and onto an outer surface of the contact on a first side of the evaporator section and/or the epoxy resin extends over the at least part of the evaporator section onto an outer surface of the contact on a second side of the evaporator section.

In an example, the epoxy resin comprises glass-fiber-reinforced thermoplastic.

In an example, the evaporator section is mounted at a position of the contact of the circuit breaker that has a groove that extends over the at least part of the contact. Thus, the evaporator section can be slid over an end of the contact and then "clicks" into the groove and is held in place in the correct position. Epoxy resin can then be applied over the whole evaporator section to fix it in position, and provide a gas tight seal.

Acording to an example, the evaporator section is mounted on a raised section of the contact of the circuit breaker. A step joins the raised section to a lower section of the contact on a first side of the raised section and/or a step joins the raised section to a lower section of the contact on a second side of the raised section. The epoxy resin extends over the step on the first side and/or extends over the step on the second side.

In an example, the condenser section is located at a higher elevation than the evaporator section.

Thus, the cooling apparatus can be a thermosyphon system where gravity is used to passively return condensed working fluid to the evaporator. The thermosyphon functioning can however be augmented via capillary action if necessary.

In an example, the evaporator section encircles the contact of the circuit breaker, wherein a fluid channel within the evaporator section is configured such that the working fluid can contact an outer surface of the contact that extends around the contact, and wherein the fluid channel fluidly connects to the fluid conduit.

In this way, cooling of the current carrying contact is further improved, because the working fluid can be heated and turned into the vapour state at a surface encircling the current carrying contact.

In an example, the fluid channel is comprised within the evaporator section.

In an example, the cooling apparatus comprises the current carrying contact, and the fluid channel is comprised within the evaporator section and/or the current carrying contact.

In an example, the fluid channel comprises a copper tube extending around the current carrying contact.

Figs. 2-7 also relate to a cooling apparatus for a medium voltage switchgear that comprises an evaporator section, two fluid conduits, and a condenser section. The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to each of the two fluid conduits. At least part of the evaporator section is electrically insulating. The at least part of the evaporator section that is electrically insulating is connected to each of the two fluid conduits. Each of the two fluid conduits is fluidly connected to the condenser section. The cooling apparatus is configured such that in use a working fluid in the evaporator section is heated to a vapour state, and the vapour is transferred by a first fluid conduit of the two fluid conduits to the condenser section, and the vapour in the condenser section is condensed to the working fluid, and the condensed working fluid is passively returned via a second fluid conduit of the two fluid conduits to the evaporator section.

In an example, a part of each of the two fluid conduits that is connected to the evaporator section is electrically insulating.

In an example, the evaporator section is configured to be affixed to a fixed contact or a movable contact of a circuit breaker of the medium voltage switchgear.

In an example, the evaporator section is configured to slide over an end of the fixed contact or slide over an end of the movable contact.

In an example, a metallic wick is comprised within the second of the two fluid conduits.

Figs. 2-7 also relate to a medium voltage switchgear that comprises a circuit breaker, and a cooling apparatus with two fluid conduits as described above. The cooling apparatus is affixed to a contact of the circuit breaker, where the contact is a fixed contact of the circuit breaker or is a movable contact of the circuit breaker.

Acording to an example, the evaporator section of the cooling apparatus surrounds at least part of the contact of the circuit breaker such that fluid within the evaporator section can contact an outer surface of the contact of the circuit breaker that extends over the at least part of the contact. An epoxy resin extends over at least a part of the evaporator section and onto an outer surface of the contact on a first side of the evaporator section and/or the epoxy resin extends over the at least part of the evaporator section and onto an outer surface of the contact on a second side of the evaporator section.

In an example, the epoxy resin comprises glass-fiber-reinforced epoxy resin.

In an example, the evaporator section is mounted at a position of the contact of the circuit breaker that has a groove that extends over the at least part of the contact. Thus, the evaporator section can be slid over an end of the contact and then "clicks" into the groove and is held in place in the correct position. Epoxy resin can then be applied over the whole evaporator section to fix it in position, and provide a gas tight seal.

In an example, the evaporator section is mounted on a raised section of the contact of the circuit breaker. A step joins the raised section to a lower section of the contact on a first side of the raised section and/or a step joins the raised section to a lower section of the contact on a second side of the raised section, and the epoxy resin extends over the step on the first side and/or extends over the step on the second side.

In an example, the condenser section is located at a higher elevation than the evaporator section.

Thus, Figs. 2-7 also relate to a method of cooling at least one part of a medium voltage or high voltage switchgear with a cooling apparatus. The cooling apparatus comprising an evaporator section, a fluid conduit, and a condenser section. The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to the fluid conduit. At least part of the evaporator section is electrically insulating. The at least part of the evaporator section that is electrically insulating is connected to the fluid conduit. The fluid conduit is fluidly connected to the condenser section. The method comprises: heating a working fluid in the evaporator section to a vapour state; transferring the vapour by the fluid conduit to the condenser section; condensing the vapour in the condenser section to the working fluid; and passively returning the condensed working fluid via the fluid conduit to the evaporator section.

In an example, the evaporator section is configured to completely surround the current carrying contact of a medium voltage switchgear. Thus, the evaporator section encircles the currying carrying contact.

In an example, the current carrying contact is configured to connect to a primary contact, that for example is configured to connect to a terminal of a circuit breaker of the switchgear.

In an example, the evaporator section is ring shaped.

In an example, the evaporator section comprises an insulating material such as thermoplastic.

In an example, the evaporator section comprises plastic and/or rubber materials.

In an example, the working fluid is electrically insulating.

In an example, the working fluid can be a refrigerant such as hydrofluorocarbons (e.g. R134a, R245fa), fluorketones (e.g., NOVEC-649™, commercially available from 3M),

In an example, a part of the fluid conduit that is connected to the evaporator section is electrically insulating.

In an example, the part of the fluid conduit connected to the evaporator section comprises an insulating material such as thermoplastic.

In an example, the part of the fluid conduit connected to the evaporator section comprises an electrically insulating tube.

In an example, the evaporator section is configured to be affixed to a fixed contact or a movable contact of a circuit breaker of the medium voltage switchgear.

In an example, the evaporator section is configured to slide over an end of the fixed contact or slide over an end of the movable contact.

In an example, a part of the fluid conduit comprises a metallic bellows, such that the part of the fluid conduit comprising the metallic bellows can bend and/or extend longitudinally.

In an example, a first part of the fluid conduit on the condenser section side of the part that comprises a metallic bellows is metal and a second part of the fluid conduit on the evaporator section side of the part that comprises a metallic bellows is metal. The first part is configured to be fixed to a wall of a compartment of the medium voltage switchgear.

In an example, at least part of the fluid conduit comprises a metallic tube.

In an example, a metallic wick is comprised within the fluid conduit.

Thus, Figs. 2-7 also relate to a method of cooling at least one part of a medium voltage or high voltage switchgear with a cooling apparatus. The cooling apparatus comprises an evaporator section, two fluid conduits, and a condenser section. The evaporator section is configured to surround at least part of a current carrying contact of a medium voltage switchgear. The evaporator section is configured such that fluid within the evaporator section can contact an outer surface of the current carrying contact that extends over the at least part of the current carrying contact. The evaporator section is fluidly connected to each of the two fluid conduits. At least part of the evaporator section is electrically insulating. The at least part of the evaporator section that is electrically insulating is connected to each of the two fluid conduits. Each of the two fluid conduits is fluidly connected to the condenser section. And the method comprises: heating a working fluid in the evaporator section to a vapour state; transferring the vapour by a first fluid conduit of the two fluid conduits to the condenser section; condensing the vapour in the condenser section to the working fluid; and passively returning the condensed working fluid via a second fluid conduit of the two fluid conduits to the evaporator section.

In an example, a part of each of the two fluid conduits that is connected to the evaporator section is electrically insulating.

In an example, the evaporator section is configured to be affixed to a fixed contact or a movable contact of a circuit breaker of the medium voltage switchgear.

In an example, the evaporator section is configured to slide over an end of the fixed contact or slide over an end of the movable contact.

In an example, a metallic wick is comprised within the second of the two fluid conduits.

The cooling apparatuses for a medium voltage or high voltage switchgear, and methods of cooling at least one part of a medium voltage or high voltage switchgear with a cooling apparatus, are further described in specific detail, where reference is again made to Figs. 2-7.

The new technique of cooling involves providing an evaporator (evaporator section), the insulating section of a thermosyphon (that is part of the evaporator and that can be part of fluid conduit(s) where they attach to the evaporator) and metallic tube(s) (fluid conduits) placed inside a circuit breaker compartment of a gas insulated switchgear. The fluid conduit or conduits then lead a cooling fluid to a condenser (condenser section) outside of the compartment. The evaporator section can be placed directly at the fixed contact of a pole part of a vacuum interrupter and herewith inside a current leading path. The vacuum interrupter is known to be the most critical thermal hotspot of a gas insulated switchgears, and as such efficient and effective cooling of this part if provided. This way the gas tightness and electrical insulation is provided by the evaoporator section itself and the fluid conduits that attach to the evaporator section, because epoxy resin is used to fix these parts to the contact of the circuit breaker and the epoxy part itself provides for a gas tight as well as securing the evaporator section to the contact. Then no additional bushing or sealings are needed. Also, in this manner the cooling liquid of the heat pipe is in direct contact with the contact of the circuit breaker and so connected to the hot spot. The heat can be dissipated outside the switchgear compartment to the condenser section.

Fig. 2 shows a polepart of a circuit breaker including a connection of the thermosiphon as described above. The insulated section is provided by an insulating part made of a thermosetting material directly casted behind the contact (see Fig. 2). Alternatively, the evaporator is placed on the moving contact of the pole part in a similar way. The condenser, as a cold end of the cooling apapratus, is placed outside the circuit breaker compartment or even outside the panel (switchgear). As a compensation element a metallic bellow can be inserted inside the tube connection. The metallic bellow is used as compensation element for the tube in case mechanical loads or vibrations occur.

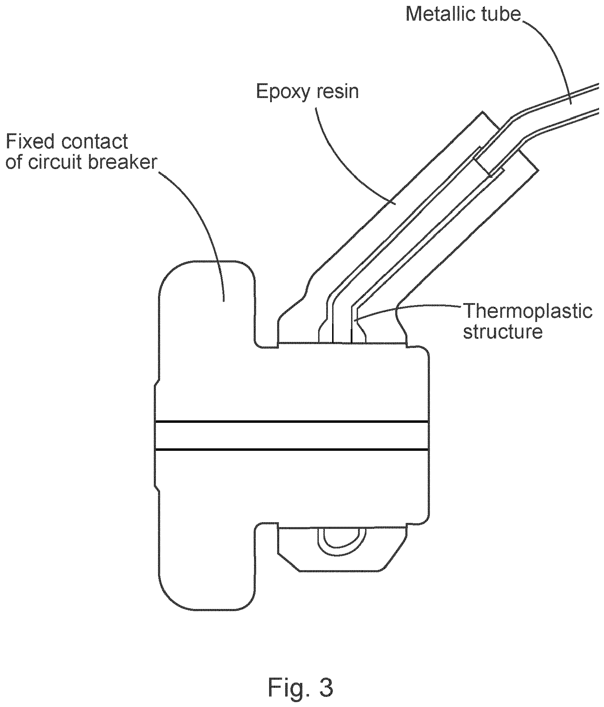

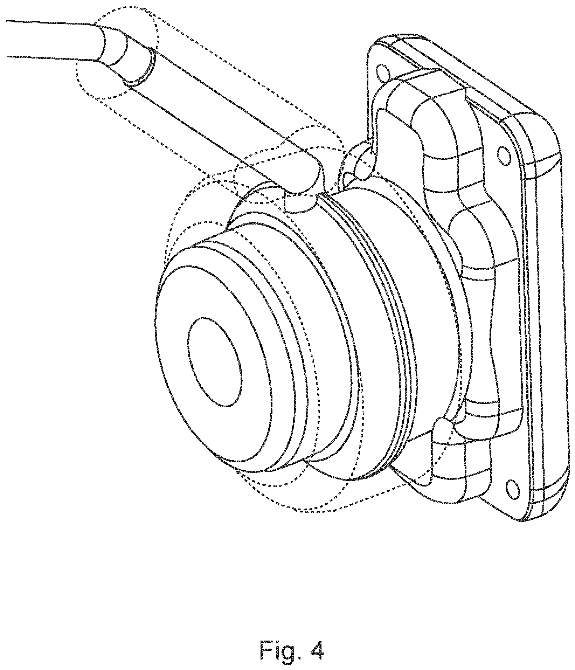

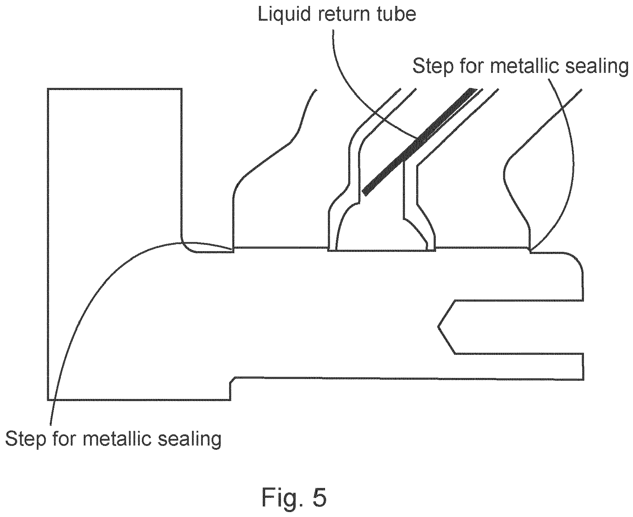

Fig. 3 shows a cross-sectional view of evaporator section, that has been affixed to a fixed contact of a circuit breaker and Fig. 4 shows further details of the embedded thermoplastic structure that has been clipped onto the fixed contact of circuit breaker before the epox resin has been applied. The epoxy resin is shown in faint detail to indicate where it will reside. Thus, the electrical insulating part of the thermosiphon is provided by a thermoplastic ring including a snorkel embedded in epoxy resin to lead both the liquid and gaseous phases of the insulating fluid. The thermoplastic part is clipped onto a groove on a cylindrical section of the fixed contact of the circuit breaker (see Figure 3 and Figure 4). The fixed contact can be made of conductive material such as Aluminum or copper. The copper conductor of the further current path towards the cable connection can be screwed at the front surface of the cylindrical section. For simplification of the casting process, a metallic step can be added at the fixed contact to provide a metallic sealing during the epoxy casting process (see Fig. 5, which shows the step at the fixed contact for metallic sealing by an epoxy casting process).

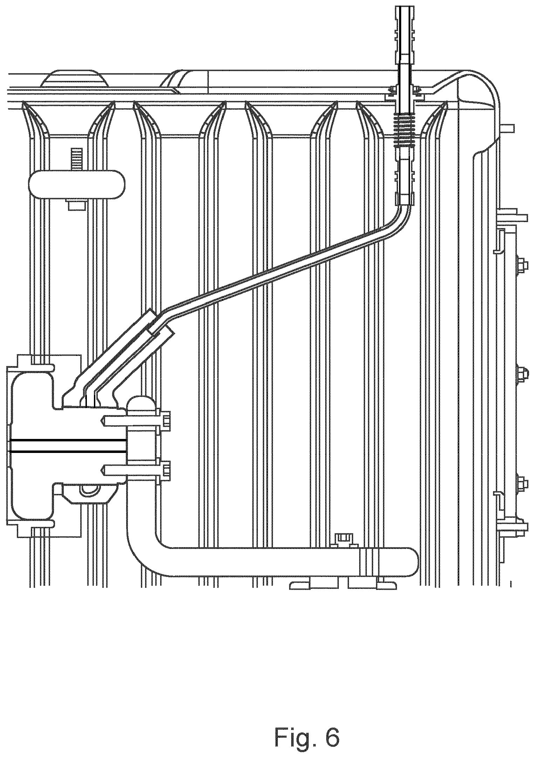

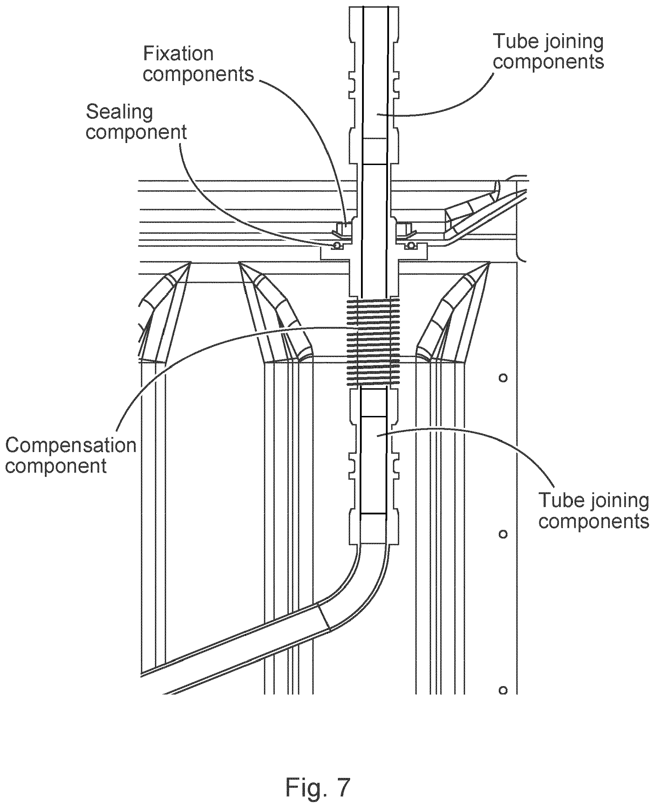

Fig. 6 shows a cross-sectional view of parts of the cooling apparatus together with connection components that lead to outside of the compartment (gas tank) of the switchgear. The gas tight bushing through the compartment sidewall is provided by an assembly group with a metallic bellow (see Fig. 6 at the top). This is shown in more detail in Fig. 7, which shows a cross-sectional view of connection components of the heat-pipe to outside of the tank with the compensation component shows - the bellows. In Fig. 7 the parts consist of a bellow, which is from one side connected to a bush and from the other side to a tube and serves as compensation element of the tube in case of the occurrence of thermal load cycles or in case of vibrations resulting from operation of the circuit breaker. The bush as a part of thr compensation component assembly is then connected with the tank structure in order to be able to further connect the tube with a condenser and sealed either by means of a sealing component or by means of gas tight welding. The tube joining components are provided for ease of installation.

To further improve the cooling performance a liquid return line can be inserted into the tubing path leading the liquid phase of the fluent. The liquid return line can consist of an electrically insulating material such as a polymer or elastomer. The line should extend to as close to the hot end as possible (see Fig. 5). Thus, rather than use just one fluid conduit linking the evaporator section to the condenser section a closed loop consisting of two or more tubes can be used to allow a circulation of the liquid and gaseous phase of the fluid, thereby improving efficiency.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

## Claims

1. A cooling apparatus for a medium voltage switchgear, the cooling apparatus comprising:
- an evaporator section;
- a fluid conduit; and
- a condenser section;
wherein, the evaporator section is configured to surround at least part of a current carrying contact of a medium voltage switchgear;
wherein, the evaporator section is configured such that fluid within the evaporator section can contact an outer surface of the current carrying contact that extends over the at least part of the current carrying contact;
wherein, the evaporator section is fluidly connected to the fluid conduit;
wherein, at least part of the evaporator section is electrically insulating and wherein that at least part of the evaporator section that is electrically insulating is connected to the fluid conduit;
wherein, the fluid conduit is fluidly connected to the condenser section; and
wherein, the cooling apparatus is configured such that in use a working fluid in the evaporator section is heated to a vapour state, and wherein the vapour is transferred by the fluid conduit to the condenser section, and wherein the vapour in the condenser section is condensed to the working fluid, and wherein the condensed working fluid is passively returned via the fluid conduit to the evaporator section.

2. Cooling apparatus according to claim 1, wherein a part of the fluid conduit that is connected to the evaporator section is electrically insulating.

3. Cooling apparatus according to any of claims 1-2, wherein the evaporator section is configured to be affixed to a fixed contact or a movable contact of a circuit breaker of the medium voltage switchgear.

4. Cooling apparatus according to claim 3, wherein the evaporator section is configured to slide over an end of the fixed contact or slide over an end of the movable contact.

5. Cooling apparatus according to any of claims 1-4, wherein a part of the fluid conduit comprises a metallic bellows, such that the part of the fluid conduit comprising the metallic bellows can bend and/or extend longitudinally.

6. Cooling apparatus according to any of claims 1-5, wherein at least part of the fluid conduit comprises a metallic tube.

7. Cooling apparatus according to any of claims 1-6, wherein a metallic wick is comprised within the fluid conduit.

8. A medium voltage switchgear, comprising:
- a circuit breaker; and
- a cooling apparatus according to any of claims 1-7;
wherein the cooling apparatus is affixed to a contact of the circuit breaker, wherein the contact is a fixed contact of the circuit breaker or is a movable contact of the circuit breaker.

9. Medium voltage switchgear according to claim 8,
wherein the evaporator section of the cooling apparatus surrounds at least part of the contact of the circuit breaker such that fluid within the evaporator section can contact an outer surface of the contact of the circuit breaker that extends over the at least part of the contact, and wherein an epoxy resin extends over at least a part of the evaporator section and onto an outer surface of the contact on a first side of the evaporator section and/or onto an outer surface of the contact on a second side of the evaporator section.

10. Medium voltage switchgear according to claim 9,
wherein the evaporator section is mounted on a raised section of the contact of the circuit breaker, wherein a step joins the raised section to a lower section of the contact on a first side of the raised section and/or wherein a step joins the raised section to a lower section of the contact on a second side of the raised section, and wherein the epoxy resin extends over the step on the first side and/or extends over the step on the second side.

11. A cooling apparatus for a medium voltage switchgear, the cooling apparatus comprising:
- an evaporator section;
- two fluid conduits; and
- a condenser section;
wherein, the evaporator section is configured to surround at least part of a current carrying contact of a medium voltage switchgear;
wherein, the evaporator section is configured such that fluid within the evaporator section can contact an outer surface of the current carrying contact that extends over the at least part of the current carrying contact;
wherein, the evaporator section is fluidly connected to each of the two fluid conduits;
wherein, at least part of the evaporator section is electrically insulating and wherein that at least part of the evaporator section that is electrically insulating is connected to each of the two fluid conduits;
wherein, each of the two fluid conduits is fluidly connected to the condenser section; and
wherein, the cooling apparatus is configured such that in use a working fluid in the evaporator section is heated to a vapour state, and wherein the vapour is transferred by a first fluid conduit of the two fluid conduits to the condenser section, and wherein the vapour in the condenser section is condensed to the working fluid, and wherein the condensed working fluid is passively returned via a second fluid conduit of the two fluid conduits to the evaporator section.

12. A medium voltage switchgear, comprising:
- a circuit breaker; and
- a cooling apparatus according to claim 11;
wherein the cooling apparatus is affixed to a contact of the circuit breaker, wherein the contact is a fixed contact of the circuit breaker or is a movable contact of the circuit breaker.

13. Medium voltage switchgear according to claim 12, wherein the evaporator section of the cooling apparatus surrounds at least part of the contact of the circuit breaker such that fluid within the evaporator section can contact an outer surface of the contact of the circuit breaker that extends over the at least part of the contact, and wherein an epoxy resin extends over at least a part of the evaporator section and onto an outer surface of the contact on a first side of the evaporator section and/or onto an outer surface of the contact on a second side of the evaporator section.

14. A method of cooling at least one part of a medium voltage or high voltage switchgear with a cooling apparatus, the cooling apparatus comprising:
- an evaporator section;
- a fluid conduit; and
- a condenser section;
wherein, the evaporator section is configured to surround at least part of a current carrying contact of a medium voltage switchgear;
wherein, the evaporator section is configured such that fluid within the evaporator section can contact an outer surface of the current carrying contact that extends over the at least part of the current carrying contact;
wherein, the evaporator section is fluidly connected to the fluid conduit;
wherein, at least part of the evaporator section is electrically insulating and wherein that at least part of the evaporator section that is electrically insulating is connected to the fluid conduit;
wherein, the fluid conduit is fluidly connected to the condenser section; and
wherein, the method comprises:
heating a working fluid in the evaporator section to a vapour state;
transferring the vapour by the fluid conduit to the condenser section;
condensing the vapour in the condenser section to the working fluid; and
passively returning the condensed working fluid via the fluid conduit to the evaporator section.

15. A method of cooling at least one part of a medium voltage or high voltage switchgear with a cooling apparatus, the cooling apparatus comprising:
- an evaporator section;
- two fluid conduits; and
- a condenser section;
wherein, the evaporator section is configured to surround at least part of a current carrying contact of a medium voltage switchgear;
wherein, the evaporator section is configured such that fluid within the evaporator section can contact an outer surface of the current carrying contact that extends over the at least part of the current carrying contact;
wherein, the evaporator section is fluidly connected to each of the two fluid conduits;
wherein, at least part of the evaporator section is electrically insulating and wherein that at least part of the evaporator section that is electrically insulating is connected to each of the two fluid conduits;
wherein, each of the two fluid conduits is fluidly connected to the condenser section; and
wherein, the method comprises:
heating a working fluid in the evaporator section to a vapour state;
transferring the vapour by a first fluid conduit of the two fluid conduits to the condenser section;
condensing the vapour in the condenser section to the working fluid; and
passively returning the condensed working fluid via a second fluid conduit of the two fluid conduits to the evaporator section.
